# EUROPÄISCHE PATENTSCHRIFT

(11) **EP 1 856 485 B1**
(45) Veröffentlichungstag und Bekanntmachung des Hinweises auf die Patenterteilung: **02.06.2010**
(21) Anmeldenummer: 06708706.4
(22) Anmeldetag: 09.03.2006
(51) Int. Cl.: G01D 5/245

(54) **ZWEI-KANAL-VERFAHREN ZUM STÄNDIGEN ERMITTELN ZUMINDEST EINES AUSGANGSSIGNALS AUS SICH ÄNDERNDEN EINGANGSSIGNALEN**
TWO-CHANNEL METHOD FOR CONTINUOUSLY DETERMINING AT LEAST ONE OUTPUT SIGNAL FROM VARYING INPUT SIGNALS
PROCEDE BICANAL DE DETERMINATION CONTINUE D'AU MOINS UN SIGNAL DE SORTIE A PARTIR DE SIGNAUX D'ENTREE VARIABLES

(30) Priorität: 11.03.2005 DE 102005011406
(43) Veröffentlichungstag der Anmeldung: 21.11.2007
(73) Patentinhaber: SIEMENS AKTIENGESELLSCHAFT, 80333 München (DE)
(72) Erfinder: SCHWESIG, Günter, 91054 Erlangen (DE); KUHN, Andreas, 91056 Erlangen (DE)
(86) Internationale Anmeldenummer: PCT/EP2006/060604
(87) Internationale Veröffentlichungsnummer: WO 2006/095012

(56) Entgegenhaltungen:
- US-A- 4 079 374
- US-A- 4 989 001
- US-A1- 2002 173 931
- PATENT ABSTRACTS OF JAPAN Bd. 1995, Nr. 05, 30. Juni 1995 (1995-06-30) -& JP 07 036512 A (TOEI DENKI KK), 7. Februar 1995 (1995-02-07)

## Beschreibung

Die vorliegende Erfindung betrifft die Auswertung von Signalen, wie sie optische oder magnetische Gebersysteme, die an Motoren an einer Werkzeugmaschine angebaut sein können, ausgeben. Sie betrifft insbesondere ein Verfahren nach dem Oberbegriff von Patentanspruch 1

Die Erfindung betrifft auch einen integrierten Schaltkreis zur Auswertung der Signale von dem Gebersystem sowie ein solches Gebersystem zusammen mit einem integrierten Schaltkreis.

Die vorliegende Erfindung gehört zu dem Bereich "Sicherheit bei der Antriebs- und Steuerungstechnik für z.B. Werkzeugmaschinen". In einer Werkzeugmaschine dient ein Motor u.a. zur Änderung der Lage und Geschwindigkeit bzw. Drehgeschwindigkeit eines Werkzeugs. Um diese Lage und Geschwindigkeit zu erfassen, sind direkt am Motor z.B. magnetische oder optische Gebersysteme angeordnet. Beispielsweise umfassen optische Gebersysteme eine Leuchtdiode, welche über einen mit Schlitzen versehene Glasscheibe, die sich mit dem Motor dreht, Licht zu zwei Fototransistoren sendet. Die Signale der Fototransistoren sind die Ausgangssignale des Gebersystems und sind insbesondere sinus- und kosinusförmig. Diese Signale müssen so ausgewertet werden, dass man zumindest einen Lageistwert für das Werkzeug erhält. Ferner sollte man aus der Lage und der Abtastzeit auch die Drehzahl oder Geschwindigkeit des Werkzeugs bestimmen können. Der Lagesollwert ist durch die Geometrie des zu bearbeitenden Werkstücks vorgegeben. Die Lageregelung verwendet den Lageistwert zur Einstellung des Lagesollwerts.

Zur Erzeugung des Lageistwerts werden die Sinus- und Kosinuskurven mit Elektronik interpoliert. Ein Analog-Digital-Wandler wandelt die analogen Signale in digitale um, und es wird die Zahl der Null-Durchgänge der Sinus- bzw. Kosinuskurven ermittelt, um festzustellen, die wievielte Sinus- bzw. Kosinuskurve gegenwärtig von dem Gebersystem ausgegeben wird. Zur Feinermittlung des Winkels wird der Sinus durch den Kosinus geteilt und von diesem Wert der Arcus Tangens ermittelt. Weil die mit Schlitzen versehene Glasscheibe z.B. 2048 Schlitze umfasst, erhält man pro Umdrehung des Motors 2048 Sinus- bzw. Kosinuskurven. Der Arcus Tangens kann abermals in z.B. 2048 Einzelschritte aufgelöst sein. Man erhält somit pro Umdrehung des Motors ca. vier Millionen mögliche Informationen.

Die genannte Elektronik ist jedoch sehr störanfällig. Um der Störanfälligkeit Rechnung zu tragen, wird im Stand der Technik mit zwei Kanälen gearbeitet:
Die Signale von dem Geber werden unabhängig voneinander in zwei gleichartigen Kanälen aufbereitet. Der von einem Kanal ermittelte Lageistwert wird mit dem Lageistwert verglichen, der in dem anderen Kanal ermittelt wird. Stimmen die Lageistwerte innerhalb bestimmter Toleranzen überein, wird der Lageistwert eines der beiden Kanäle als Ausgangssignal verwendet. Stimmen die Lageistwerte der beiden Kanäle nicht miteinander überein, erfolgt eine Fehlermeldung. Da die Lageregelung nicht mehr zuverlässig arbeiten kann, wird die Maschine als Ganzes angehalten.

Eine Forderung des TÜVs bzw. der Berufsgenossenschaft ist es, dass die beiden Kanäle, welche durch elektronische Elemente auf Siliziumchips bereitgestellt sind, nicht auf dem selben Chip bereitgestellt werden oder zumindest durch einen Siliziumgraben voneinander getrennt sind. Grund hierfür ist, dass sonst in den Kanälen 1 und 2 Fehler gleicher Art auftreten können, welche durch den Vergleich der Kanäle untereinander nicht zu entdecken sind.

Das Vorsehen zweier verschiedener Chips hat hohe Kosten und einen hohen Platzbedarf zur Folge. Es müssen mehrere Gehäuse bereitgestellt sein. Die Lösung mit dem Siliziumgraben ist zwar eine mögliche Lösung, ist aber unwirtschaftlich, weil die Grabenbreite je nach Umgebungstemperaturbereich entsprechend breit ausgeführt sein muss. Eine Temperaturerhöhung, welche durch einen Defekt im Kanal hervorgerufen ist, darf nicht zu einer unzulässigen Temperaturerhöhung im anderen Kanal führen. Entsprechend nimmt der Siliziumflächenanteil des Grabens bei Anwendungen mit hohen zulässigen Umgebungstemperaturen in unwirtschaftlicher Weise zu.

In dem US-Patent 4,079,374 ist ein System zum Analysieren von sinus- und kosinusförmigen Eingangssignalen beschrieben, denen durch einen Resolver eine Phase aufgeprägt ist. Ein erster Phase-Locked-Loop gibt die Phase aus. Es kann ein zweiter Phase-Locked-Loop bereitgestellt sein, der eine Ableitung der Phase ausgibt.

Es ist Aufgabe der Erfindung, eine kompakte Lösung bereitzustellen, wie die Gebersignale auf einem Siliziumchip verarbeitet werden können und gleichzeitig die Sicherheit der Überwachung der beiden Kanäle gewährleistet sein kann.

Die Aufgabe wird durch ein Verfahren gemäß Patentanspruch 1 und einen integrierten Schaltkreis gemäß Patentanspruch 6 sowie durch Gebersystem mit einem solchen integrierten Schaltkreis gelöst.

Die Erfindung beruht auf der Erkenntnis, dass zwar zwei verschiedene Kanäle vorliegen müssen, dass aber auf jeden Fall nur ein einziges Ausgangssignal erforderlich ist. Somit kann jeweils in einem Kanal die Herstellung des Ausgangssignals erfolgen und im anderen Kanal überprüft werden, ob dieser korrekt arbeitet. Dadurch, dass dies abwechselnd geschieht, im Umschaltbetrieb (Multiplexer), behält man eine hohe Geschwindigkeit bei der Erfassung von Fehlern in einem der Kanäle.

Hierzu erfolgt an jeweils einem der Kanäle die Zufuhr der Eingangssignale und die Entnahme des Ausgangssignals, und dem jeweils anderen der Kanäle werden Testeingangssignale zugeführt, zu denen ein Erwartungswert für das Ausgangssignal bekannt ist, und aus diesen Testeingangssignalen wird über den üblichen Weg das Ausgangssignal ermittelt und mit dem Erwartungswert verglichen, um zu prüfen, ob der jeweils andere Kanal korrekt arbeitet, während gleichzeitig der eine Kanal zur Herstellung des Ausgangssignals dient.

Der integrierte Schaltkreis weist hierzu auf:
- einen ersten Kanal zum Erzeugen zumindest eines Ausgangssignals aus sich ändernden Eingangssignalen und
- einen abwechselnd mit dem ersten Kanal eingesetzten gleichartigen zweiten Kanal, ebenfalls zum Erzeugen des Ausgangssignals aus den sich ändernden Eingangssignalen,
- einen Umschalter (Multiplexer) zum Umschalten zwischen den Kanälen,
- eine Einrichtung zum Herstellen von Testeingangssignalen und
- eine Datenverbindung von der Einrichtung zum Umschalter für das abwechselnde Zuführen der Testeingangssignale zu jeweils dem Kanal, der gegenwärtig nicht für das Erzeugen des Ausgangssignals eingesetzt wird.

Da die Eingangssignale in der Regel Analogsignale sind, umfasst jeder Kanal bevorzugt einen Analog-Digital-Wandler sowie eine nachgeschaltete digitale Auswerteschaltung und/oder einen Mikroprozessor zum Auswerten der digitalen Signale. Bevorzugt stellt der Mikroprozessor in einem der Kanäle die Testeingangssignale bereit, welche dann über einen Digital-Analog-Wandler in der Datenverbindung in analoge Testeingangssignale umgewandelt werden.

Der Umschalter kann von dem Mikroprozessor mit einem Umschaltsignal gesteuert sein.

Bei einer bevorzugten Ausführungsform werden die Eingangssignale dem zweiten Kanal mit umgekehrter Polung zugeführt. Das Sinussignal und das Kosinussignal werden daher in ihrer Rolle vertauscht. Entsprechend muss die Signalaufbereitung an den vertauschten Signaleingang angepasst sein, und auch die Testsignale müssen entsprechend aufgeschaltet werden.

Es wird nun eine bevorzugte Ausführungsform der Erfindung unter Bezug auf die Zeichnungen beschrieben, in der:
- FIG 1: den Aufbau eines Systems zum Verarbeiten von Gebersignalen gemäß dem Stand der Technik zeigt, und
- FIG 2: den Aufbau eines Systems zum Verarbeiten von Gebersignalen gemäß der Erfindung darstellt.

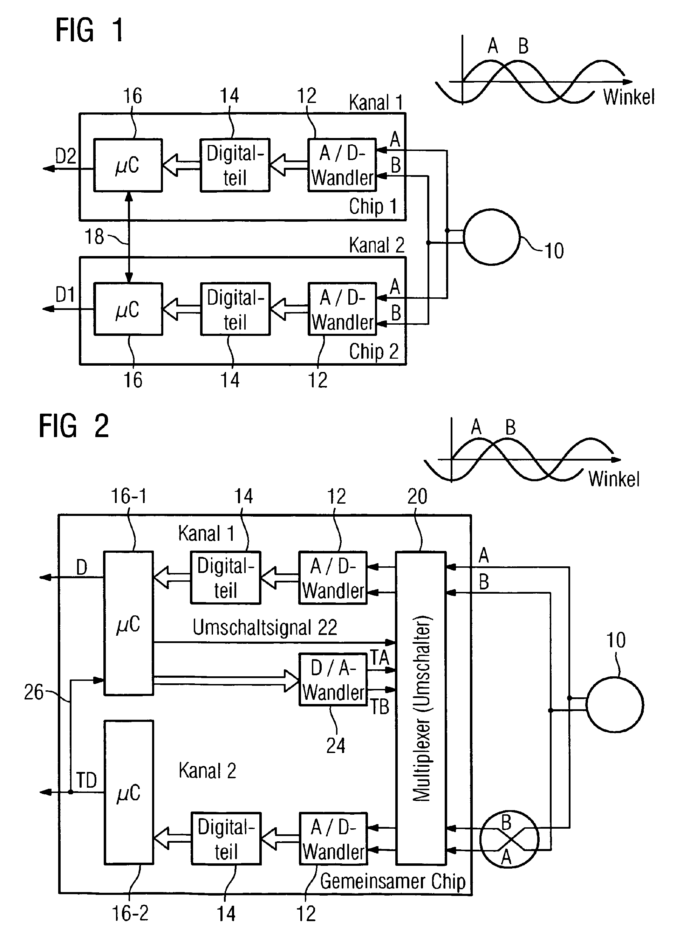

Ein Geber 10, der ein optischer oder magnetischer Geber sein kann, gibt als Eingangssignale für zwei Kanäle auf zwei verschiedenen Chips das Sinussignal A und das Kosinussignal B aus. In jedem Chip wandelt ein Analog-Digital-Wandler 12 die analogen Signale in digitale Signale um. In einem Digitalteil 14 sowie in einem nachgeschalteten Mikrocomputer 16 erfolgt die weitere Auswertung des Signals. Die Zahl der Null-Durchgänge des Sinus steht dabei für das Ausmaß der Drehung des Motors, den das Gebersystem beobachtet, und zur Feinmessung wird der genaue Winkel des Eingangssignals erfasst, indem der Arcus Tangens aus dem Verhältnis des Signals A zum Signal B berechnet wird. Die beiden Mikrocomputer 16 geben Signale D1 und D2 aus, welche jeweils die Lage eines Werkzeugs oder Werkstücks repräsentieren. Die beiden Signale D1 und D2 werden über eine Verbindungsleitung 18 miteinander verglichen, wobei bevorzugt der Vergleich in beiden Mikrocomputern 16 erfolgen kann. Weichen die Werte D1 und D2 zu weit voneinander ab, wird stattdessen ein Fehler- und Haltesignal ausgegeben, aufgrund dessen der Motor anhält. Die beiden Kanäle 1 und 2 sind, wie dargestellt, auf verschiedenen Chips angeordnet. Die zweikanalige Ausführungsform erscheint hier sehr aufwendig und wenig effektiv, aus Gründen der Sicherheit aber notwendig. Die Erfindung, die in FIG 2 dargestellt ist, ermöglicht nun die Ausführung der Kanäle auf einem gemeinsamen Chip. Auch hier sind Analog-Digital-Wandler 12, Digitalteile 14 und Mikrocomputer 16 vorgesehen. Den Analog-Digital-Wandlern vorgeschaltet ist jedoch ein Multiplexer (Umschalter) 20. Der Multiplexer empfängt die Signale A und B von dem Geber, wobei hinsichtlich des Kanals 2 die Schaltung über Kreuz erfolgt, d.h., ein Austausch der Signaleingänge für A und B erfolgt ist, was seitens des zugehörigen Mikrocomputers zu berücksichtigen ist.

Einer der Mikrocomputer, hier im Beispiel der Mikrocomputer 16-1, hat nun eine hervorgehobene Bedeutung (Master). Der andere Mikrocomputer 16-2, bleibt demgegenüber von untergeordneter Bedeutung (Slave). Der Computer 16-1 sendet in Abhängigkeit von den von ihm empfangenen Daten einerseits ein Umschaltsignal 22 an den Multiplexer 20, und andererseits sendet er Testeingangssignale TA und TB über einen Digital-Analog-Wandler 24 an den Multiplexer. Im gezeigten Fall liegen nun die Eingangssignale A und B am Kanal 1 an. Der Kanal 1 erzeugt ein Ausgangssignal D. Dieses wird zur Lageregelung und Drehzahlregelung verwendet. Gleichzeitig erfolgt ein Test des Kanals 2:
Der Kanal 2 wird mit den Testsignalen TA und TB beaufschlagt, und diese Signale werden im Kanal 2 ausgewertet, als handle es sich um gewöhnliche Signale A und B. Der Mikrocomputer 16-2 gibt nun ein Testausgangssignal TD aus, welches über eine Datenleitung 26 an den Mikrocomputer 16-1 übermittelt wird. Der Mikrocomputer vergleicht, ob das Testausgangssignal TD mit dem Erwartungswert für die Testeingangssignale TA und TB übereinstimmt. Falls dies der Fall ist (gegebenenfalls innerhalb bestimmter Toleranzen), gibt er das Umschaltsignal 22 aus. Es wird nun der Eingang vom Kanal 1 abgetrennt, und stattdessen schaltet der Multiplexer 20 auf Kanal 2 um, der nunmehr die echten Signale B und A empfängt. Damit dient das Ausgangssignal aus dem Mikrocomputer 16-2 zur Lageregelung, während nun gleichzeitig dem Eingang des Kanals 1 die Testsignale TA und TB zugeführt werden. Auch hier wird verglichen, ob das sich ergebende Endsignal in Übereinstimmung mit dem Erwartungswert der Testsignale TA und TB ist.

Die Testsignale TA und TB können an die jeweils aktuellen Signale A und B angepasst sein, wobei der Mikrocomputer diese Testsignale anhand von Formeln berechnen kann oder einer Tabelle für Testeingangssignale und Erwartungswerte entnehmen kann.

Bei der Erfindung wird also immer ein Kanal zur Erzeugung des Ausgangssignals verwendet, und zeitgleich wird der andere Kanal daraufhin überprüft, ob er noch korrekt arbeitet. Dadurch, dass recht schnell zwischen den beiden Kanälen gewechselt wird (beispielsweise im Sekundentakt) können Fehler, die beispielsweise nach einigen Stunden Betriebslaufzeit auf einmal auftreten, verhältnismäßig schnell erkannt werden. Da die Kanäle unabhängig und abwechselnd voneinander betrieben werden, können sie nun auf einem gemeinsamen Chip untergebracht werden. Hieran dürfte auch der TÜV nichts mehr zu bemängeln haben.

## Patentansprüche

1. Verfahren zum ständigen Ermitteln zumindest eines Ausgangssignals aus sich ändernden Eingangssignalen (A,B), bei dem die Eingangssignale (A,B) zwei voneinander unabhängigen Kanälen zugeführt werden, die aus Elementen (12,14,16) auf einem Chip bestehen, in denen eine gleichartige Signalaufbereitung der Eingangssignale zur Erzeugung eines Ausgangssignals (D) in jedem Kanal erfolgt, **dadurch gekennzeichnet, dass** abwechselnd gleichzeitig an jeweils einem der Kanäle die Zufuhr der Eingangssignale (A,B) und die Entnahme des Ausgangssignals (D) erfolgt und an den jeweils anderen der Kanäle Testeingangssignale (TA,TB) zugeführt werden, zu denen ein Erwartungswert für das Ausgangssignal bekannt ist, und dass das dort aus den Testeingangssignalen ermittelte Ausgangssignal (TD) mit dem Erwartungswert verglichen wird, um zu überprüfen, ob der jeweils andere Kanal korrekt arbeitet, während der eine Kanal zur Herstellung des Ausgangssignals (D) dient.

2. Verfahren nach Anspruch 1, **dadurch gekennzeichnet, dass** die Eingangssignale Signale aus einem magnetischen oder optischem Gebersystem zugehörig zu einem Element einer Maschine sind, und dass zumindest das eine Ausgangssignal den Lageistwert des Elements der Maschine wiedergibt.

3. Verfahren nach Anspruch 2, **dadurch gekennzeichnet, dass** die Eingangssignale einen Sinus- und Kosinuswert umfassen, und dass die Signalaufbereitung die Zählung der Null-Durchgänge der Kurven und die Ermittlung der Arcus Tangens zum Verhältnis der beiden Eingangssignale zueinander umfasst.

4. Verfahren nach einem der vorhergehenden Ansprüche, **dadurch gekennzeichnet, dass** ein Fehler- oder Haltesignal ausgegeben wird, wenn das Ausgangssignal nicht innerhalb eines Toleranzrahmens mit dem Erwartungswert übereinstimmt.

5. Verfahren nach Anspruch 1, **dadurch gekennzeichnet, dass** die Eingangssignale analoge Signale von Sensoren sind.

6. Integrierter Schaltkreis mit Elementen (12, 14, 16), die zwei voneinander unabhängige Kanäle bilden, in denen eine gleichartige Signalaufbereitung von sich ändernden Eingangssignalen (A, B) zur Erzeugung eines Ausgangsignals (D) in jedem Kanal erfolgt,
**dadurch gekennzeichnet, dass** der integrierte Schaltkreis noch folgende Elemente aufweist:
- einen Multiplexer (20) zum Umschalten zwischen den Kanälen, so dass abwechselnd gleichzeitig an jeweils einem der Kanäle die Zufuhr der Eingangssignale (A, B) und die Entnahme des Ausgangsignals (D) erfolgt,
- einer Einrichtung zum Bereitstellen, an den jeweils anderen der Kanäle, von Testeingangssignalen (TA, TB), zu denen ein Erwartungswert für das Ausgangssignal bekannt ist, und zum Vergleichen des Erwartungswertes mit einem aus den Testeingangssignalen ermittelten Ausgangssignal (TD), und
- einer Datenverbindung von der Einrichtung zum Multiplexer (20) für das abwechselnde Zuführen der Testeingangssignale zu jeweils dem Kanal, der gegenwärtig nicht für das Erzeugen des Ausgangssignals eingesetzt wird.

7. Integrierter Schaltkreis nach Anspruch 6, **dadurch gekennzeichnet, dass** jeder Kanal einen Analog-Digital-Wandler (12) umfasst sowie eine digitale Auswerteschaltung (14) und/oder einen Mikroprozessor (16-1, 16-2) umfasst.

8. Integrierter Schaltkreis nach Anspruch 7, **dadurch gekennzeichnet, dass** die Datenverbindung einen Digital-Analog-Wandler (24) umfasst.

9. Integrierter Schaltkreis nach einem der Ansprüche 6 bis 8, **dadurch gekennzeichnet, dass** die Einrichtung zum Herstellen von Testeingangssignalen ein Mikroprozessor (16-1) in einem der Kanäle ist.

10. Integrierter Schaltkreis nach Anspruch 7, **dadurch gekennzeichnet, dass** der Mikroprozessor (16-1) den Multiplexer mit einem Umschaltsignal (22) steuert.

11. Integrierter Schaltkreis nach einem der Ansprüche 6 bis 10, **dadurch gekennzeichnet, dass** die Eingangssignale (A,B) dem zweiten Kanal mit umgekehrter Polung zugeführt werden.

12. Magnetisches oder optisches Gebersystem an einem Element einer Maschine, das zwei Signale ausgibt, die für einen dem Gebersystem nachgeschaltenen integrierten Schaltkreis nach einem der Ansprüche 6 bis 10 als Eingangssignale dienen, wobei das Ausgangssignal des Chips von einer elektronischen Lageregelung für das Element als Istwertsignal verwendet wird.

## Claims

1. Method for continuously determining at least one output signal from changing input signals (A, B), wherein the input signals (A, B) are supplied to two mutually independent channels consisting of elements (12, 14, 16) on one chip, in which the input signals are conditioned in the same way in order to generate an output signal (D) in each channel,
**characterised in that** the input signals (A, B) are in alternation simultaneously supplied to and the output signal (D) taken from in each case one of the channels, and test input signals (TA, TB) for which an expected value for the output signal is known are supplied to the respective other of the channels, and **in that** the output signal (TD) determined there from the test input signals is compared with the expected value to check whether the respective other channel is operating correctly, while the one channel serves simultaneously for producing the output signal (D).

2. Method according to claim 1, **characterised in that** the input signals are signals from a magnetic or an optical transducer system associated with an element of a machine, and **in that** at least the one output signal indicates the actual position value of the element of the machine.

3. Method according to claim 2, **characterised in that** the input signals include a sinusoidal and cosinusoidal value, and **in that** the signal conditioning includes counting the zero crossings of the curves and determining the tangential arc in terms of the ratio of the two input signals.

4. Method according to one of the preceding claims,
**characterised in that** an error or stop signal will be output if the output signal does not tally within tolerance limits with the expected value.

5. Method according to claim 1, **characterised in that** the input signals are analogue signals of sensors.

6. Integrated circuit comprising elements (12, 14, 16) which form two mutually independent channels in which changing input signals (A, B) are conditioned in the same way in order to generate an output signal (D) in each channel,
**characterised in that** the integrated circuit also has the following elements:
- a multiplexer (20) for changing over between the channels, so that the input signals (A, B) are in alternation simultaneously supplied to and the output signal (D) taken from in each case one of the channels,
- a device for providing test input signals (TA, TB), for which an expected value for the output signal is known, to the respective other of the channels, and for comparing the expected value with an output signal (TD) determined from the test input signals, and
- a data link from the device to the multiplexer (20) for supplying the test input signals in an alternating manner to in each case the channel currently not being used for generating the output signal.

7. Integrated circuit according to claim 6,
**characterised in that** each channel includes an analogue-to-digital converter (12) and a digital evaluation circuit (14) and/or a microprocessor (16-1, 16-2).

8. Integrated circuit according to claim 7,
**characterised in that** the data link includes a digital-to-analogue converter (24).

9. Integrated circuit according to one of claims 6 to 8,
**characterised in that** the device for producing test input signals is a microprocessor (16-1) in one of the channels.

10. Integrated circuit according to claim 7,
**characterised in that** the microprocessor (16-1) controls the multiplexer by means of a changeover signal (22).

11. Integrated circuit according to one of claims 6 to 10,
**characterised in that** the input signals (A, B) are supplied to the second channel with reversed polarity.

12. Magnetic or optical transducer system which is attached to an element of a machine and which outputs two signals serving as input signals for an integrated circuit according to one of claims 6 to 10 connected downstream of the transducer system, with the output signal of the chip being used by an electronic position controller for the element as an actual-value signal.

## Revendications

1. Procédé de détermination continue d'au moins un signal de sortie à partir de signaux ( A, B ) d'entrée variables, dans lequel on envoie les signaux ( A, B ) d'entrée dans deux canaux indépendants l'un de l'autre, qui sont constitués d'éléments ( 12, 14, 16 ) sur une puce, dans lesquels s'effectue un traitement de même type des signaux d'entrée pour la production d'un signal ( D ) de sortie dans chaque canal, **caractérisé en ce qu'**on effectue en alternance en même temps, sur respectivement l'un des canaux, l'envoi des signaux ( A, B ) d'entrée et les prélèvements du signal ( D ) de sortie et, sur respectivement l'autre des canaux, on envoie des signaux ( TA, TB ) d'entrée de test, pour lesquels une valeur à laquelle on s'attend du signal de sortie est connue, et **en ce qu'**on compare à la valeur à laquelle on s'attend le signal ( TD ) de sortie, qui y est déterminé à partir de signaux d'entrée de test, pour vérifier si l'autre canal respectif fonctionne de manière correcte, tandis que le un canal sert à la production du signal ( D ) de sortie.

2. Procédé suivant la revendication 1, **caractérisé en ce que** les signaux d'entrée sont des signaux provenant d'un système générateur magnétique ou optique associé à un élément d'une machine et **en ce qu'**au moins un signal de sortie reproduit la valeur réelle en position de l'élément de la machine.

3. Procédé suivant la revendication 2, **caractérisé en ce que** les signaux d'entrée comprennent une valeur sinus et une valeur cosinus et **en ce que** le traitement du signal comprend le comptage des passages par zéro des courbes et la détermination des arcs tangents pour le rapport des deux signaux d'entrée entre eux.

4. Procédé suivant l'une des revendications précédentes, **caractérisé en ce qu'**on émet un signal d'erreur ou d'arrêt, si le signal de sortie ne coïncide pas, à une plage de tolérance près, avec la valeur à laquelle on s'attend.

5. Procédé suivant la revendication 1, **caractérisé en ce que** les signaux d'entrée sont des signaux analogiques de capteurs.

6. Circuit intégré, comprenant des éléments ( 12, 14, 16 ), qui forment des canaux indépendants les uns des autres, dans lesquels un traitement du signal du même type de signaux ( A, B ) d'entrée variables s'effectue pour la production d'un signal ( D ) de sortie dans chaque canal, **caractérisé en ce que** le circuit intégré a encore les éléments suivantes :
- un multiplexeur ( 20 ), pour commuter entre les canaux, de manière à effectuer en alternance en même temps sur respectivement l'un des canaux l'envoi des signaux ( A, B ) d'entrée et le prélèvement du signal ( D ) de sortie,
- un dispositif, pour mettre à disposition sur respectivement l'autre canal des signaux ( TA, TB ) d'entrée de test, pour lesquels on connaît une valeur à laquelle on s'attend du signal de sortie et pour la comparaison de la valeur à laquelle on s'attend à un signal ( TD ) de sortie déterminé à partir des signaux d'entrée de test, et
- une liaison de données allant du dispositif au multiplexeur ( 20 ), pour l'envoi en alternance des signaux d'entrée de test à respectivement le canal, qui actuellement n'est pas utilisé pour la production du signal de sortie.

7. Circuit intégré suivant la revendication 6, **caractérisé en ce que** chaque canal comprend un convertisseur ( 12 ) analogique-numérique ainsi qu'un circuit ( 14 ) numérique d'exploitation et/ou un microprocesseur ( 16-1, 16-2 ).

8. Circuit intégré suivant la revendication 7, **caractérisé en ce que** la liaison de données comprend un convertisseur ( 24 ) numérique-analogique.

9. Circuit intégré suivant l'une des revendications 6 à 8, **caractérisé en ce que** le dispositif de production de signaux d'entrée de test est un microprocesseur ( 16-1 ) dans l'un des canaux.

10. Circuit intégré suivant la revendication 7, **caractérisé en ce que** le microprocesseur ( 16-1 ) commande le multiplexeur par un signal ( 22 ) de commutation.

11. Circuit intégré suivant l'une des revendications 6 à 10, **caractérisé en ce que** les signaux ( A, B ) d'entrée sont envoyés au deuxième canal en ayant une polarité inversée.

12. Système émetteur magnétique ou optique sur un élément d'une machine, qui émet deux signaux, qui servent de signaux d'entrée pour un circuit intégré suivant l'une des revendications 6 à 10 monté en aval du système émetteur, dans lequel le signal de sortie de la puce est utilisé comme signal de valeur réelle par une régulation électronique de position de l'élément.
